# EUROPEAN PATENT APPLICATION

(11) **EP 4 669 040 A1**
(43) Date of publication of application: **24.12.2025**
(21) Application number: 24183684.0
(22) Date of filing: 21.06.2024
(51) Int. Cl.: H05K 7/14

(54) **POWER CONVERTER RACK**

(71) Applicant: Hitachi Energy Ltd, 8050 Zürich (CH)
(72) Inventor: Hilal, Alaa, 6040 Jumet (BE); Lakshmikanth, Rakesh, 560091 Bangalore (IN)
(74) Representative: Michalski Hüttermann & Partner Patentanwälte mbB

(57) **Abstract**

The invention relates to a power converter rack (1) comprising a plurality of sliding elements (4) arranged one above another inside the rack (1), a plurality of power converter modules (3) configured for each being carried on a respective sliding element (4) of the plurality of sliding elements (4) for being slid into and out of the rack (1) and each power converter module (3) of the plurality of power converter modules (3) comprising a flexible power cable (6) connecting the respective power converter module (3) with the rack (1), and at least one fan (10) configured for being carried on another one of the plurality of sliding elements (4) for being slid into and out of the rack (1).

## Description

### Technical Field

The invention relates to a power converter rack comprising a plurality of power converter modules and at least one fan.

### Background Art

Power converter racks comprising a plurality of power converter modules are known from prior art. Such power converter racks typically do not have side and back access, since the power converter racks are often installed next to each other and against a wall having converter power connections in a back side for safety reasons. Thus, any intervention for maintenance, service or converter replacement is only possible through front access. As such, fixed power connections is not an option as a service engineer, which should be able to disconnect and remove the power converter from a front.

To achieve quick and easy converter connection and for better system serviceability, in prior installations a busbar plugin system is usually used together with a converter plugin kit. The power converter can then be inserted and pushed inside the rack until the power converter is plugged to busbars of the busbar plugin system allowing power connection. Besides such quick and easy power connection, one biggest advantage of such system is easy of service, with only front access required to the rack. Indeed, with such systems there is no need for side or back access to rack which are usually inaccessible when racks are installed next to each other and against walls.

Said plugin system works quite well but it is extensively expensive, heavy and time consuming to install. Specifically, the rack equipped with this plugin system is almost three times more expensive than a normal rack, due to copper bars, special busbar holders and plugin kit making up the converter power connection. Other disadvantages of such plugin system are that it is not easy and time consuming to install, while it also makes the rack much heavier than the rack needs to be almost doubling a weight of the rack.

Further, since the converter racks are often installed next to each other and against a wall and converter power connections in a back side for safety reasons as mentioned before, often centrifugal cooling fans are positioned at a roof top of the rack allowing hot air coming from all power converters to exit the rack. These fans are often installed in a fan box with perforated panels on sides of the rack to allow air to exit while achieving ingress protection from mechanical risks.

As hot air exiting from each converter is obstructed by the plugin busbar system to reach rack fans, this creates a higher flow resistance which leads to less efficient cooling. Also, the use of centrifugal fans to overcome a higher pressure drop and let air to exit from the sides create more noise due to change of air flow direction. As a result, such cooling solution exceeds noise limit requirements and restricts a number of power converters to be used in one rack respectively do not sufficiently cool power converters. Another disadvantage, fan maintenance is not easy and time consuming. More importantly, rack cooling fan noise reaches beyond 75dB making it the biggest drawback of the thermal design.

### Summary of invention

It is therefore an object of the invention to provide a more efficient power connection for power converters installable in a power converter rack and a lower-noise lower-cost cooling solution for such power converter rack.

The object of the invention is solved by the features of the independent claim. Preferred implementations are detailed in the dependent claims.

Thus, the object is solved by a power converter rack comprising
a plurality of sliding elements arranged one above another inside the rack,
a plurality of power converter modules configured for each being carried on a respective sliding element of the plurality of sliding elements for being slid into and out of the rack and each power converter module of the plurality of power converter modules comprising a flexible power cable connecting the respective power converter module with the rack, and
at least one fan configured for being carried on another one of the plurality of sliding elements for being slid into and out of the rack.

A key point of the proposed solution thus lies in withdrawing before described prior art plugin solution for reducing assembly time, weight and especially cost. Before described disadvantages are in particular overcome by a cable solution. However, cabling usually means a fixed-type solution not allowing to disconnect the power converter module without access to a connection point, in particular side or back access. It is thus proposed to replace the expensive prior art plugin solution with an innovative simple solution that achieves the advantages of the plugin system but at a much lower cost. Specifically, the proposed solution uses only flexible power cables to connect the power converter module in the rack, i.e., no need for expensive parts such as copper bars, holders, handles and plugs. In sum, the key point thus lies in a cable routing inside the rack allowing the power converter modules to be easily installed and removed with only front access.

The proposed flexible power cable is preferably connected with one end to a common busbar which may go through a cable tray preferably placed strategically between rack shelfs and a rack side panel. The flexible power cable may exit the tray at each unit level defined by a respective sliding element for going towards a front of the rack and then rolling towards a backside of the power converter module where the flexible power cable is connected with another end to a converter power terminal of the respective power converter module. In addition, an external support can be easily connected in front of the power converter module to be removed of the rack. The power converter module can then be pulled out off the rack with an additional cable length allowing the power converter module to be removed while still electrically connected via the flexible power cable to the common busbar. Thereby, the flexible power cable can be foreseen to sit in a gap made available on shelfs next to the power converter module.

Thus, in one preferred implementation, when the power converter module is inserted in the rack via the sliding element, the flexible power cable may follow the power converter module preferably on a shelf next to the power converter module where a gap is made available. When a power converter module is pulled out of the rack, the flexible power cable may unroll and follow the power converter module until the power converter module is outside the rack and accessible, for example, for service or replacement. The flexible power cables are preferably fixed at two points on the shelf and/or the sliding element where it doesn't need to move to ensure support for a moving part of the sliding element. The flexible power cables are preferably fixed to a back panel of the power converter module to avoid stressing a power connecter of the flexible power cable.

The proposed solution further uses in particular axial fans which are mounted inside the rack preferably very close to a hot air source, in preferably just on top of the power converter modules. The at least one fan is preferably mounted just above a clear space behind the power converter modules, when seen from the front. The at least one fan is preferably installed above an upmost first power converter module with direct access to hot air exiting from all power converter modules, thus allowing hot air to reach the at least one fan faster. Such low resistance to air flow makes in particular axial fans sufficient for required cooling purpose which in turn reduces noise levels.

Thus, the proposed solution allows for a cost reduction, since the solution reduces cooling cost by 30% using cheaper fans, while allowing to install more power converter modules in one rack. Further, noise can be reduced from 76dB to only 65dB. Since the at least one fan can be positioning nearer to a hot air source of the power converter modules, more efficient cooling and minim obstruction can be achieved, and possibility to increase number of power converter modules that can be installed in the rack.

The rack preferably comprises 5, 8, 10 or 15 sliding elements arranged in regular distances one above another such wise defining respective shelfs for accommodating a respective power converter module. By means of such sliding element, a respective power converter module can be slid preferably in a horizontal direction into and out of the rack. When sliding into and out of the rack, the respective flexible power cable preferably follows the power converter module. Preferably, the power converter module is connected by means of a connector to the power converter module. Such wise, when the power converter module has been slid out of the rack, the connector can be disconnected from the power converter module for aerially removing the power converter module from the rack. The at least one fan is preferably carried by one of the plurality of sliding elements not occupied by a power converter module. The rack is preferably provided as 19" rack, whereby the power converter module are preferably dimensioned for being inserted in such 19" rack. Alternatively, the rack may be 600mm or 800mm width.

According to a preferred implementation, each of the plurality of sliding elements are provided as two opposite arranged in particular horizontally extending angle sections and/or guiding elements attached to opposite inner sides of the rack. The power converter module can then be place respectively slid in and out onto the angle sections and/or guiding elements The angle sections and/or guiding elements are preferably arranged in regular distances to each other and/or one above another.

In another preferred implementation, each of the plurality of sliding elements is provided as two opposite arranged in particular horizontally extending sliding rails, preferably of which a part can be slid together with the respective power converter module or the at least one fan carried thereon out of the rack. Such sliding rail can be attached with another part to the rack, such that an easy sliding of the respective power converter module or the at least one fan carried thereon can be achieved.

According to a further preferred implementation, the power converter rack comprises at least two fans and/or whereby the at least one fan is provided as an axial fan. Preferably, the at least two fans comprise two, three or four fans, which are further preferably arranged close together in one or two rows, for example.

In another preferred implementation, the at least one fan and the plurality of power converter modules are arranged horizontally offset to another when being slid into the rack. Thus, the at least one fan can be mounted preferably just above and/or in a clear space behind converters.

According to a further preferred implementation, the rack comprises a tray configured for being carried on the another one of the plurality of sliding elements, whereby the at least one fan is mounted on the tray. Mounting the at least one fan on such tray which can installed and removed easily by sliding it in and out the rack allows for an easy and quick fan replacement during maintenance. Thereby, fans can be easily installed by only requiring front access to the rack. The tray can be fixed with screws in a front only as in a rear its movement can be restricted by tabs on rear corner posts. The another one of the plurality of sliding elements means in particular a sliding element which is not occupied by a power converter module.

In another preferred implementation, the at least one fan is arranged vertically in particular adjacent above the plurality of power converter modules and/or the at least one fan and an upmost arranged power converter module of the plurality of power converter modules are carried on adjacent sliding elements. Preferably, the at least one fan is arranged just on top of the upmost arranged power converter module. The at least one fan thus has direct access to hot air exiting from all power converter modules, allowing hot air to reach fan faster. This low resistance to air flow makes the at least one fans sufficient for the purpose which in turn reduces the noise levels of the rack.

According to a further preferred implementation, the power converter rack comprises an exhaust arranged on a top surface of the rack, in particular comprising a perforated sheet. Such exhaust allows for change air flow direction. Air pushed by the at least one fan can be smoothly turned by the exhaust and exit from a top front of the rack. This allows installing racks next to one another and against a wall without impacting cooling performance. Compared to prior art solutions where air exits in all directions, cooling was compromised when the rack was installed against a wall or next to other racks. Said problem is solved by the exhaust with air exiting preferably only from a top of the rack.

In another preferred implementation, the power converter rack comprises a plurality of busbars connecting the respective flexible power cables. Such busbars are preferably arranged vertically above all power converter modules. Preferably, the rack-comprises one busbar associated to each phase of the flexible power cable. The term flexible means preferably that the cable can be bend when sliding the power converter module in and out of the rack.

According to a further preferred implementation, the power converter rack comprises a vertically extending cable tray configured for guiding the respective flexible power cable when sliding the respective power converter into and out of the rack. Preferably, the flexible power cable is firmly attached at one or more sections to the vertically extending cable tray. Vertically extending cable tray preferably extends along all power converter modules up to the common busbar.

In another preferred implementation, the flexible power cable tray is arranged between the plurality of sliding elements and a wall of the rack. Providing such gap allows the flexible power cable to respectively extract or distract when sliding in and sliding out of the power converter module.

According to a further preferred implementation, the flexible power cable is attached at least in part to the respective sliding element. Thus, when sliding in or sliding out the power converter module preferably in horizontal direction into respectively out of the rack, the flexible power cable follows the sliding element in a defined manner.

In another preferred implementation, the plurality of power converter modules are each provided as an inverter, in particular as a three phase inverter and/or configured for inverting 800 VDC to 400 VAC. Preferably, each power converter module is configured for converting 30 kW, 40 kW or 50 kW. The rack preferably comprises 5, 8, 10, 15 or power converter modules and/or is configured for being equipped with 5, 8, 10, 15 or power converter modules. The flexible power cable is preferably designed respectively dimensioned for carrying such electrical loads.

### Brief description of drawings

These and other aspects of the invention will be apparent from and elucidated with reference to the implementations described hereinafter.

In the drawings:
Fig. 1 shows a part of a power converter rack in a side view according to a preferred implementation,
Fig. 2 shows the part of the power converter rack of Fig. 1 in a perspective front side view according to the preferred implementation,
Fig. 3 shows another part of the power converter rack of Fig. 1 in a perspective back side view according to the preferred implementation,
Fig. 4 shows another part of the power converter rack of Fig. 1 in a perspective back side view according to the preferred implementation,
Fig. 5 shows another part of a power converter rack of Fig. 1 in a side view according to a preferred implementation, and
Fig. 6 shows a power converter rack in a back view according to another preferred implementation.

### Description of implementations

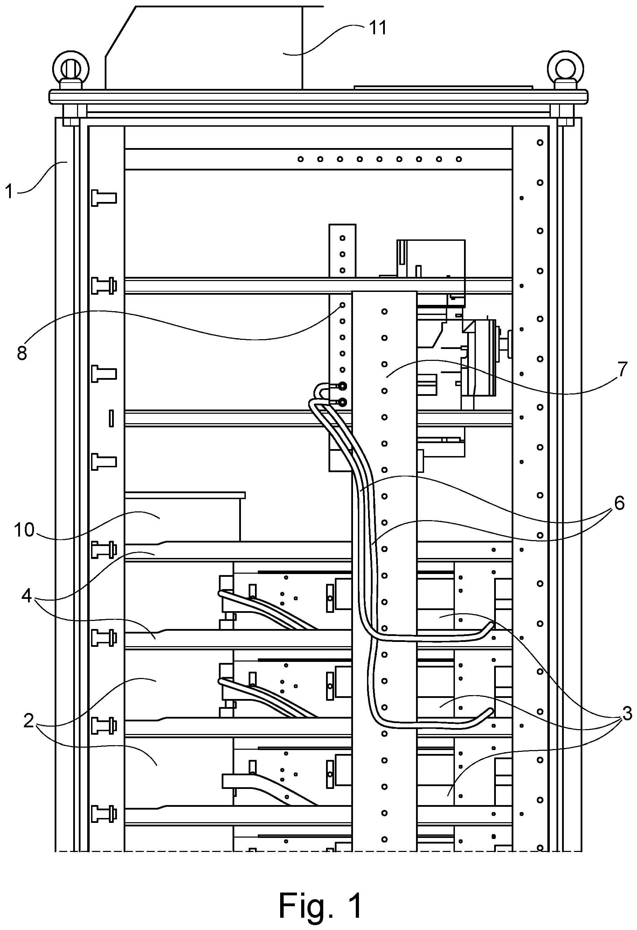

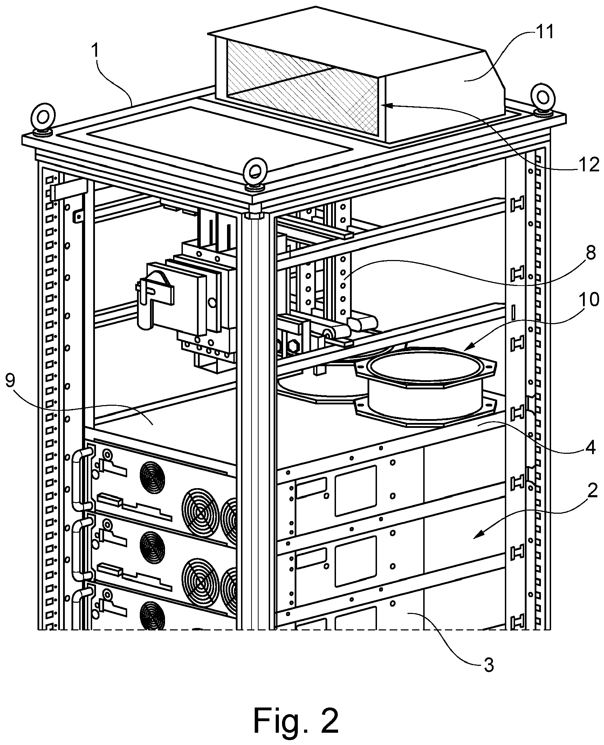

Fig. 1 shows a part of a power converter rack 1 in a side view according to a preferred implementation, while Fig. 2 shows the part of the power converter rack 1 of Fig. 1 in a perspective front side view according to the preferred implementation. The power converter rack 1 of Fig. 1 is shown with a side opened, while, during normal operation, both sides as well as the backside of the rack 1 are closed by not shown walls.

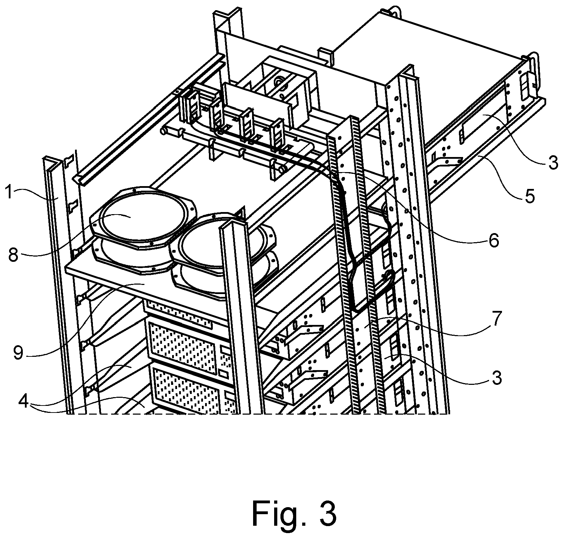

The power converter rack 1 is provided as a 19 inches respectively 482.6 mm wide rack and comprises a plurality of shelfs 2 for carrying power converter modules 3 having a cubic size which fits for being inserted into the 19 inches rack. Said shelfs 2 comprise sliding elements 4, on which the power converter modules 3 can be carried and such wise slid into the rack 1, as shown in Fig. 3, or selectively slid out of the rack 1, as shown in Fig. 3 for the upmost arranged power converter module 3.

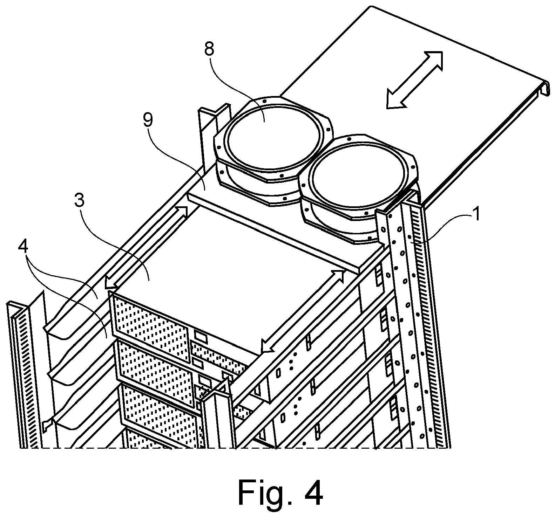

As can be in particular seen from Fig. 2 showing the part of the power converter rack 1 of Fig. 1 in a perspective front side view according to the preferred implementation, each the plurality of sliding elements 4 are arranged one above the other in, in respect to the power converter modules 3 inserted into the respective shelfs 2, regular distances and are attached to inner sides of the rack 1. Fig. 4 shows four cubic power converter modules, which are provided as inverters for inverting 800 VDC to 400 VAC.

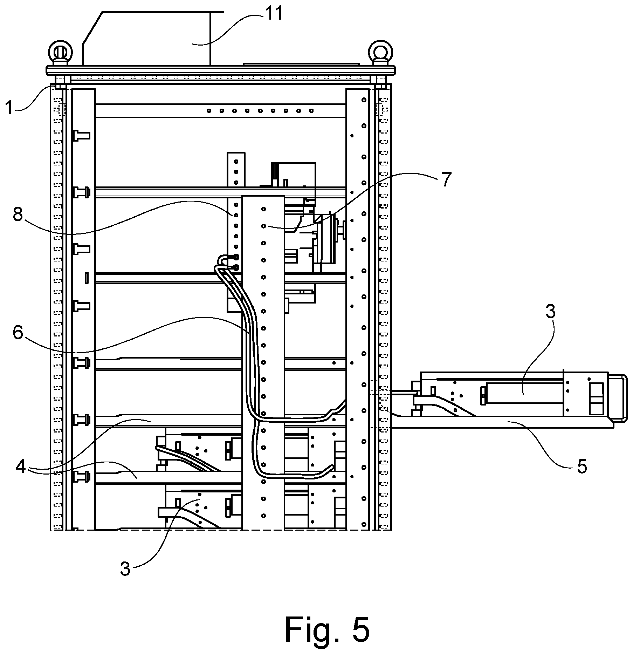

The sliding elements 4 are each provided as two opposite arranged horizontally extending angle sections attached to opposite inner sides of the rack 1, namely as sliding rails, of which a part 5 can be slid together with the respective power converter module 2 into and out of the rack 1. Each power converter module 3 can thus be placed on a respective part 5 of the sliding element 4 being slid out of the rack 1, as shown in Figs. 3 and 5 for the upmost positioned power converter module 3, and thereafter horizontally slid into the rack 1, for obtaining a position within the rack 1 as shown in Figs. 1 and 2, where the power converter modules 3 are vertically arranged one above another. Thereby, Fig. 3 shows another part of the power converter rack 1 of Fig. 1 in a perspective back side view according to the preferred implementation, while Fig. 5 shows another part of a power converter rack 1 of Fig. 1 in a side view according to a preferred implementation.

The power converter modules 3 are electrically each connected by a respective flexible power cable 6, which is plugged via a not shown connector into a back side of the respective power converter module 3. Starting from the back side, the flexible power cable 6 first runs horizontally along the sliding element 4, being partly attached to the sliding element 4, while then going upwards being guided respectively fixed by a vertically extending cable tray 7, which guides all flexible power cables 6 towards a common busbar 8, to which the flexible power cables 6 are connected phase by phase with a respective another end. Thereby, the power cable tray 7 is arranged between the sliding elements 4 and a wall of the rack 1. As the power cable 6 is provided flexible, the power converter modules 3 can be slid out of the rack 1 while being electrically connected to the busbar 8.

Such wise, for installing the power converter module 3, first the horizontally extending part 5 of the sliding element 4 can be slid out of the rack 1, then the power converter module 3 can be placed on the part 5, as indicated in Figs. 3 and 5. Thereafter, the flexible power cable 6 can be connected with its respective and to the power converter module 3 and the power converter module 3 can be slid into the rack 1, as shown in Fig. 1 and 2.

The rack 1 further comprises a tray 9, which is basically provided as metal tablet, and which is inserted in the upmost shelfs 2 respectively carried by the upmost arranged sliding elements 4. The tray 9 is equipped with two axial fans 10, arranged in a line perpendicular to a sliding direction of the power converter modules 3. Such wise the try 9 with the fans 10 can also be slid into and out of the rack 1, as shown in Fig. 4. Said Fig. 4 shows another part of the power converter rack 1 of Fig. 1 in a perspective back side view according to the preferred implementation, where the tray 9 is mostly slid of the rack 1.

As can be seen for example from Fig. 1, the fan 10 and the power converter modules 3 are arranged horizontally offset to another, when both being slid into the rack 1. Thus, hot air erupted at the backside of the power converter modules 3 can be conveyed vertically upward by the fans 10. The fans 10 are therefore installed vertically directly above an upmost arranged power converter module 3. The hot air escapes the rack 1 via an exhaust 11, which is arranged on a top surface of the rack 1 and which comprises a perforated sheet 12.

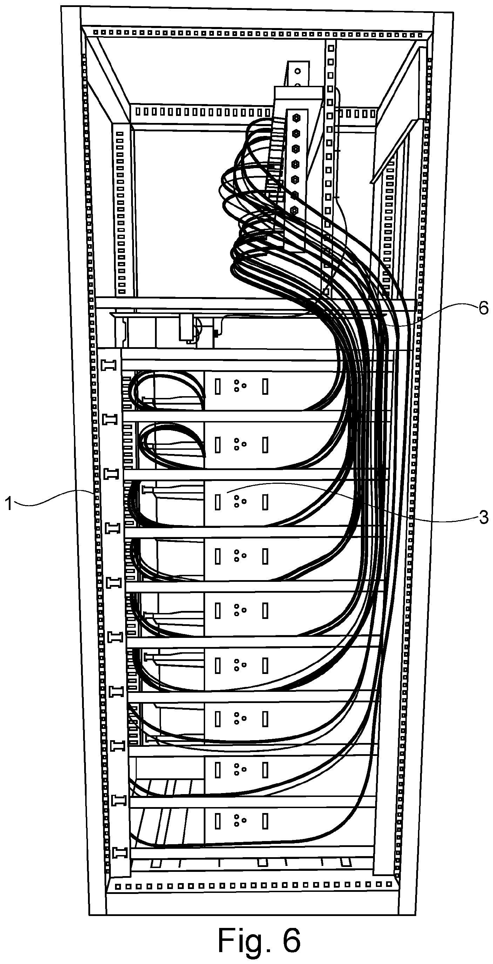

Fig. 6 shows a power converter rack 1 in a back view according to another preferred implementation. Compared to the implementations shown in Figs. 1 to 5, the flexible power cables 6 do not predominately run at a side of the rack 1, but are arranged at a backside of the rack 1.

While the invention has been illustrated and described in detail in the drawings and foregoing description, such illustration and description are to be considered illustrative or exemplary and not restrictive; the invention is not limited to the disclosed implementations. Other variations to be disclosed implementations can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 1: power converter rack
- 2: shelf
- 3: power converter module
- 4: sliding element
- 5: part
- 6: flexible power cable
- 7: power cable tray
- 8: bus bar
- 9: tray
- 10: fan
- 11: exhaust
- 12: perforated sheet

## Claims

1. Power converter rack (1) comprising
a plurality of sliding elements (4) arranged one above another inside the rack (1),
a plurality of power converter modules (3) configured for each being carried on a respective sliding element (4) of the plurality of sliding elements (4) for being slid into and out of the rack (1) and each power converter module (3) of the plurality of power converter modules (3) comprising a flexible power cable (6) connecting the respective power converter module (3) with the rack (1), and
at least one fan (10) configured for being carried on another one of the plurality of sliding elements (4) for being slid into and out of the rack (1).

2. Power converter rack (1) according to the previous claim, whereby each of the plurality of sliding elements (4) is provided as two opposite arranged in particular horizontally extending angle sections and/or guiding elements attached to opposite inner sides of the rack (1).

3. Power converter rack (1) according to any of the previous claims, whereby each of the plurality of sliding elements (4) is provided as two opposite arranged in particular horizontally extending sliding rails, preferably of which a part (5) can be slid together with the respective power converter module (3) or the at least one fan (10) carried thereon out of the rack (1).

4. Power converter rack (1) according to any of the previous claims, comprising at least two fans (10) and/or whereby the at least one fan (10) is provided as an axial fan (10).

5. Power converter rack (1) according to any of the previous claims, whereby the at least one fan (10) and the plurality of power converter modules (3) are arranged horizontally offset to another when being slid into the rack (1).

6. Power converter rack (1) according to any of the previous claims, comprising a tray (9) configured for being carried on the another one of the plurality of sliding elements (4), whereby the at least one fan (10) is mounted on the tray (9).

7. Power converter rack (1) according to any of the previous claims, whereby the at least one fan (10) is arranged vertically in particular adjacent above the plurality of power converter modules (3) and/or the at least one fan (10) and an upmost arranged power converter module (3) of the plurality of power converter modules (3) are carried on adjacent sliding elements (4).

8. Power converter rack (1) according to any of the previous claims, comprising an exhaust (11) arranged on a top surface of the rack (1), in particular comprising a perforated sheet (12).

9. Power converter rack (1) according to any of the previous claims, comprising a plurality of busbars (8) connecting the respective flexible power cables (6).

10. Power converter rack (1) according to any of the previous claims, comprising a vertically extending cable tray (7) configured for guiding the respective flexible power cable (6) when sliding the respective power converter into and out of the rack (1).

11. Power converter rack (1) according to the previous claim, whereby the power cable tray (7) is arranged between the plurality of sliding elements (4) and a wall of the rack (1).

12. Power converter rack (1) according to any of the previous claims, whereby the flexible power cable (6) is attached at least in part to the respective sliding element (4).

13. Power converter rack (1) according to any of the previous claims, whereby the plurality of power converter modules (3) are each provided as inverter, in particular as a three phase inverter and/or configured for inverting 800 VDC to 400 VAC.
